# EUROPÄISCHE PATENTSCHRIFT

(11) **EP 3 847 702 B1**
(45) Veröffentlichungstag und Bekanntmachung des Hinweises auf die Patenterteilung: **26.10.2022**
(21) Anmeldenummer: 19797171.6
(22) Anmeldetag: 04.09.2019
(51) Int. Cl.: H01L 41/053, G06F 3/01, H02N 2/04

(54) **FAHRZEUG-BEDIENEINHEIT MIT TAKTILER RÜCKMELDUNG**
VEHICLE OPERATING UNIT WITH TACTILE FEEDBACK
UNITÉ DE COMMANDE DE VÉHICULE AVEC INFORMATION DE RETOUR TACTILE

(30) Priorität: 05.09.2018 DE 102018121692
(43) Veröffentlichungstag der Anmeldung: 14.07.2021
(73) Patentinhaber: Behr-Hella Thermocontrol GmbH, 59557 Lippstadt (DE)
(72) Erfinder: KEMPPINEN, Pasi, 33800 Tampere (FI); KIRSCH, Stefan, 59494 Soest (DE)
(74) Vertreter: dompatent von Kreisler Selting Werner - Partnerschaft von Patent- und Rechtsanwälten mbB
(86) Internationale Anmeldenummer: PCT/EP2019/073550
(87) Internationale Veröffentlichungsnummer: WO 2020/049028

(56) Entgegenhaltungen:
- DE-A1-102016 116 763
- JP-A- S59 177 980
- US-A1- 2016 027 263
- US-B1- 6 273 681

## Beschreibung

Die Erfindung betrifft eine Fahrzeug-Bedieneinheit mit taktiler Rückmeldung bei manueller Betätigung mit einem Piezoantrieb.

Bei Piezoantrieben werden die Längenveränderbarkeit eines piezoelektrischen Elements in einer Wirkrichtung bei elektrischer Ansteuerung ausgenutzt, um eine zu bewegende Komponente bzw. Einheit mechanisch anzuregen. Ein Anwendungsfall in der Automobil-Industrie ist der Einsatz eines Piezoantriebs zur Erzeugung eines haptischen Feedbacks bei einer Bedienvorrichtung. Eine derartige Bedienvorrichtung weist einen Touch-Screen oder ein Touch-Pad auf, der/das kurzzeitig bzw. impulsartig mechanisch angeregt wird, wenn eine valide manuelle Bedienung detektiert worden ist. Auf diese Weise stellt sich ein haptisches Feedback ein, mit dem dem Bediener taktil eine valide Betätigung rückgemeldet wird. Insbesondere betrifft die Erfindung einen Piezoaktuator mit einem Getriebe, der in Fachkreisen auch als Piezoaktuator mit mechanischer Verstärkung bezeichnet wird.

Die Längenveränderbarkeit von Piezoaktuatoren bzw. von piezoelektrisch wirkenden Elementen derartiger Aktuatoren ist groß genug, um taktil wahrgenommen werden zu können, was aber oftmals applikationsbedingt nicht ausreichend ist. Um die Längenveränderung zu vergrößern, werden Piezoaktuatoren eingesetzt, die eine Vielzahl von aufeinandergestapelten piezoelektrischen Elementen (nachfolgend als Piezoelement bezeichnet) aufweisen. Ein derartiger Piezoaktuator wirkt mechanisch auf eine Bewegungsumsetzungskonstruktion bzw. ein entsprechendes Umsetzungsgetriebe, durch das eine Längenveränderung des Piezoaktuators in Wirkrichtung, die bei vergleichsweise hoher Kraft erfolgt, in eine größere Bewegung mit dementsprechend geringerer Kraft umgewandelt wird.

Die im Stand der Technik eingesetzten Umsetzungsgetriebe für Piezoaktuatoren weisen einen im Wesentlichen bogenförmigen Bügel auf, der an den in Wirkrichtung des Piezoaktuators liegenden Enden mit dem Piezoaktuator zumeist klebend verbunden ist. Es können zwei derartige Bügel beidseitig der Wirkachsenerstreckung des Piezoaktuators angeordnet sein. Die Bügel bestehen aus einem vergleichsweise steifen Material wie beispielsweise Metall und werden bei elektrischer Ansteuerung des Piezoaktuators gedehnt oder gestaucht, wodurch sich eine Bewegungskomponente ergibt, die in einem spitzen Winkel zur Wirkrichtung des Piezoaktuators gerichtet ist. Durch die Verformung des bzw. der Bügel kann das Material der Bügel im Laufe der Zeit ermüden, womit die Funktionstüchtigkeit des Piezoantriebs leiden kann.

Beispiele für Piezoantriebe mit Umsetzungsgetrieben sind in DE-U-20 2008 017 833, US-B-6 246 132, US-A-4 952 835, WO-A-2017/1762019, US-B-9 523 294, EP-A-3 056 977, WO-A-2014/164018, WO-A-2016/067831, US-B-6 465 936, WO-A-2014/096565, US-A-2016/0 027 263, DE-A-10 2016 116 763, JP-A-2008-287402, EP-A-1 035 015, DE-B-23 05 277, DE-C-42 14 220 und DE-B-199 81 030 beschrieben.

Aufgabe der Erfindung ist es, eine Bedieneinheit mit taktiler Rückmeldung bei manueller Betätigung mit einem Piezoantrieb zu schaffen, der über Langlebigkeit und verbesserte Funktionalität verfügt.

Zur Lösung dieser Aufgabe schlägt die Erfindung vor eine Fahrzeug-Bedieneinheit mit taktiler Rückmeldung bei manueller Betätigung, mit
- einem Gehäuse,
- einem Bedienelement, das manuell betätigbar ist, und
- einem Piezoantrieb zur pulsartigen mechanischen Anregung des Bedienelements,
- wobei der Piezoantrieb zwischen einer Gehäusewand des Gehäuses und dem Bedienelement angeordnet und versehen ist mit
   - einem Piezoaktuator aus einem piezoelektrischen Material, wobei der Piezoaktuator strangförmig ausgebildet ist und eine Längserstreckung zwischen zwei Enden ausweist und wobei die Längserstreckung des Piezoaktuators dessen Wirkrichtung definiert, längs derer der Piezoaktuator bei Ansteuerung expandiert und/oder kontrahiert, und
   - einem mechanisch mit den Längserstreckungsenden des Piezoaktuators gekoppelten Umsetzungsgetriebe zum Umsetzten einer in Wirkrichtung des Piezoaktuators erfolgenden Längenveränderung des Piezoaktuators in eine in einem Winkel von ungleich 0 Grad zur Längserstreckung des Piezoaktuators gerichteten Bewegung eines mit dem Umsetzungsgetriebe gekoppelten, zu bewegenden Elements,
   - wobei das Umsetzungsgetriebe einen ersten Bügel ausweist, der elastisch ausgebildet ist und/oder elastisches Material aufweist und der im Bereich der Längserstreckungsenden des Piezoaktuators mit diesem mechanisch gekoppelt ist,
   - wobei der erste Bügel einen ersten und einen zweiten Endabschnitt, innerhalb derer der erste Bügel jeweils mit dem Piezoaktuator mechanisch gekoppelt ist, und zwischen den beiden Endabschnitten einen schräg verlaufenden ersten Schrägabschnitt und einen im Vergleich zum ersten Schrägabschnitt kürzeren schräg verlaufenden zweiten Schrägabschnitt aufweist, die sich nach Art der Seitenschenkel eines Dreiecks mit gedachter, zwischen den Endabschnitten des Bügels verlaufender Verbindungslinie als Basis erstrecken sowie miteinander verbunden, insbesondere elastisch verbunden sind, und von denen der erste Schrägabschnitt mit dem ersten Endabschnitt und der zweite Schrägabschnitt mit dem zweiten Endabschnitt verbunden, insbesondere elastisch verbunden ist, und
- wobei der erste Bügel mit dem Bedienelement und der Piezoaktuator mit der Gehäusewand gekoppelt ist oder der erste Bügel mit der Gehäusewand und der Piezoaktuator mit dem Bedienelement gekoppelt ist.

Der Piezoantrieb der erfindungsgemäßen Bedieneinheit weist in an sich bekannter Weise einen Piezoaktuator aus einem piezoelektrischen Material auf. Der Piezoaktuator expandiert und/oder kontrahiert längs einer Wirkrichtung bei Ansteuerung mit einer elektrischen Spannung. An den in Wirkrichtung liegenden Enden des strangförmigen Piezoaktuators steht dieser mit einem Umsetzungsgetriebe in Wirkverbindung. Dieses Umsetzungsgetriebe verstärkt das Ausdehnungs- bzw. Kontraktionsmaß des Piezoaktuators in eine Bewegung größeren Hubs längs einer Bewegungsachse, die in einem spitzen Winkel zur Wirkrichtung des Piezoaktuators verläuft.

Die Besonderheit des Piezoantriebs der erfindungsgemäßen Bedieneinheit besteht in der Ausgestaltung des mindestens einen ersten Bügels des Umsetzungsgetriebes. Dieser erste Bügel weist zwei einander gegenüberliegenden Endabschnitte auf, zwischen denen der Bügel zwei schräg verlaufende erste und zweite Schrägabschnitte aufweist. Die beiden Schrägabschnitte sind untereinander verbunden, wobei ihre Enden, die den miteinander verbundenen Enden jeweils gegenüberliegen, mit jeweils einem anderen der beiden Endabschnitte verbunden sind. Damit hat der erste Bügel einen in Seitenansicht betrachtet dreieckförmigen Verlauf, wobei die beiden Schrägabschnitte die Schenkel eines Dreiecks sind, dessen Basis durch eine gedachte Verbindungslinie zwischen den beiden Endabschnitten gebildet ist.

Einer der beiden Schrägabschnitte, nämlich der erste Schrägabschnitt, ist dabei länger als der andere Schrägabschnitt, d.h. länger als der zweite Schrägabschnitt.

Die beiden erfindungsgemäß vorgesehenen Schrägabschnitte bewirken nun eine besonders effiziente Umsetzung der Längenveränderung des Piezoaktuators in dessen Wirkrichtung in eine in einem spitzen Winkel zur Längserstreckung des Piezoaktuators gerichtete Bewegung eines zu bewegenden Elements. Der Bügel des Umsetzungsgetriebes des Piezoantriebs weist lediglich drei flexible Zonen auf, in denen der Bügel eine Materialverformung erfährt, wenn der Piezoaktuator elektrisch angesteuert wird. Diese reduzierte Anzahl an Materialverformungszonen erlaubt es nun, dass der Piezoantrieb über längere Zeit funktionstüchtig bleibt. Damit erhöht sich die Robustheit des Piezoantriebs bei vergleichsweise geringem Material- und Fertigungsaufwand.

In weiterer zweckmäßiger Ausgestaltung der Erfindung ist vorgesehen, dass der erste Schrägabschnitt des ersten Bügels mechanisch mit einem zu bewegenden Element in Wirkverbindung bringbar ist und dass der Piezoaktuator an einem Abstützelement abstützbar ist. Durch die mechanische Kopplung des ersten Bügels mit dem zu bewegenden Element im Bereich des ersten Schrägabschnitts werden Verkippungen des Elements bei der Bewegung des ersten Bügels reduziert. Der erste Schrägabschnitt ist gegenüber dem zweiten Schrägabschnitt vergleichsweise lang ausgebildet. Der zweite Schrägabschnitt dient sozusagen zum Abstoßen des ersten Schrägabschnitts. Die Winkelstellung beider Schrägabschnitte und ihre Längenverhältnisse bestimmen unter anderem den Bewegungshub, den das zu bewegende Element erfährt, wenn der Piezoaktuator sich bezüglich seiner Länge verändert. Die Abstützung des Piezoantriebs gegenüber einem Festpunkt erfolgt am Piezoaktuator, der an einem Abstützelement abstützbar ist.

In weiterer vorteilhafter Ausgestaltung der Erfindung ist vorgesehen, dass das Umsetzungsgetriebe einen zweiten Bügel aufweist, der gleich dem oder im Wesentlichen gleich dem ersten Bügel ausgebildet ist, wobei die Längen der ersten Schrägabschnitte der beiden Bügel unterschiedlich oder gleich oder im Wesentlichen gleich sind und die Längen der zweiten Schrägabschnitte der beiden Bügel unterschiedlich oder gleich oder im Wesentlichen gleich sind. Sowohl der Bewegungshub als auch die Kraft, mit der die Bewegung längs des Hubs ausgeführt wird, sind durch die Doppelbügel-Konstruktion des Umsetzungsgetriebes dieser Variante der Erfindung vergrößert. Die beiden Bügel sind insoweit identisch ausgebildet, als sie beide jeweils zwei Endabschnitte und jeweils einen ersten und einen zweiten Schrägabschnitt zwischen ihren beiden jeweiligen Endabschnitten aufweisen. Die Längen und Winkelstellungen der Schrägabschnitte des einen Bügels können von denen des anderen Bügels unterschiedlich sein. Zweckmäßig ist es aber, die beiden Bügel auch insoweit gleich zu konstruieren.

Bei einer Doppelbügel-Konstruktion des Umsetzungsgetriebes ist es zweckmäßig, wenn der erste Schrägabschnitt des einen der beiden Bügel mechanisch mit einem zu bewegenden Element in Wirkverbindung bringbar ist und wenn der erste Schrägabschnitt des anderen der beiden Bügel zur Abstützung des Umsetzungsgetriebes mechanisch mit einem Abstützelement koppelbar ist.

Bei der zuvor beschriebenen Konstruktion des Umsetzungsgetriebes können die beiden Bügel beidseitig der Wirkachse des Piezoaktuators gleichsinnig oder gegensinnig ausgerichtet verlaufend angeordnet sein. Im erstgenannten Fall sind die beiden ersten Schrägabschnitte und die beiden zweiten Schrägabschnitte der beiden Bügel paarweise gegenüberliegend angeordnet. Beide Paare liegen längs der Wirkachse des Piezoaktuators nebeneinander. Die Schrägabschnitte der beiden Bügel bilden im Wesentlichen eine Raute. Wenn die beiden Bügel gegensinnig ausgerichtet verlaufend beidseitig des Piezoaktuators angeordnet sind, liegt der erste Schrägabschnitt des einen Bügels dem zweiten Schrägabschnitt des anderen Bügels jeweils paarweise gegenüber. Diese beiden Paare aus jeweils einem ersten Schrägabschnitt des einen Bügels und einem zweiten Schrägabschnitt des anderen Bügels liegen nun wiederum längs der Wirkachse des Piezoaktuators nebeneinander. Damit verlaufen die ersten und zweiten Schrägabschnitte der beiden Bügel wie die Seiten eines Parallelogramms.

Wie bereits oben erwähnt, sind die beiden Schrägabschnitte des mindestens einen Bügels bzw. jedes Bügels des Umsetzungsgetriebes unterschiedlich lang. Vorteilhaft ist es beispielsweise, wenn der erste Schrägabschnitt des mindestens einen Bügels oder jedes Bügels des Umsetzungsgetriebes mindestens die 1,5-fache Länge oder mindestens die 2-fache Länge oder mindestens die 2,5-fache Länge oder mindestens die 3-fache Länge seines zweiten Schrägabschnitts aufweist.

Die ersten Schrägabschnitte beider Bügel können gleich lang sein, was auch für die zweiten Schrägabschnitte der beiden Bügel gelten kann.

Wie bereits oben erwähnt, wird als Material für die Bügel des Umsetzungsgetriebes Metall gewählt. Alternativ eignet sich aber auch Kunststoff. Entscheidend ist, dass die für die Bügel verwendeten Materialien die Funktion von Festkörpergelenken an den Verbindungen der beiden ersten Abschnitte mit den beiden Schrägabschnitten und zwischen den beiden Schrägabschnitten aufweisen können. Ein Festkörperscharnier kann beispielsweise als Filmscharnier oder aber, ganz allgemein ausgedrückt, als Verdünnung der Dicke des Bügels ausgeführt sein. Alternativ kann der Bügel aber auch End- und Schrägabschnitte aufweisen, die untereinander gelenkig verbunden sind. In jedem Fall ist der Bügel bzw. jeder Bügel insoweit elastisch verformbar, was hinsichtlich insbesondere der Verformungszonen des Bügels durch eine entsprechende Konstruktion oder aber durch eine entsprechende Materialwahl realisiert wird. Die einzelnen Abschnitte des oder jedes Bügels können aber auch durch Drehgelenkverbindungen beweglich gekoppelt sein.

In weiterer vorteilhafter Ausgestaltung der Erfindung können die Endabschnitte des mindestens einen Bügels oder jedes Bügels klebend oder mittels eines Verbindungselements mit dem Piezoaktuator mechanisch verbunden sein. Als mechanisches Verbindungselement kommt beispielsweise eine Schraube, ein Bolzen o.dgl. in Frage.

In weiterer vorteilhafter Ausgestaltung der Erfindung kann vorgesehen sein, dass der Piezoaktuator ein oder mehrere piezoelektrische Elemente aufweist, die übereinandergestapelt sind. Die Stapelfolge kann dabei in Längserstreckung des Piezoaktuators oder aber auch orthogonal dazu gerichtet sein.

Die Erfindung wird nachfolgend anhand eines Ausführungsbeispiels und unter Bezugnahme auf die Zeichnung näher erläutert. Im Einzelnen zeigen dabei:
- Fig. 1: eine schematische Darstellung einer Fahrzeugbedieneinheit von vorne mit einem Touch-Pad bzw. Touch-Screen, das/der zur Erzeugung eines haptischen Feedback und damit zur taktilen Rückmeldung einer manuellen Berührungseingabe von einem Piezoantrieb pulsartig angeregt wird, und
- Fig. 2: eine perspektivische Darstellung des Piezoantriebs, wie er in der Fahrzeugbedieneinheit gemäß Figur 1 eingesetzt wird.

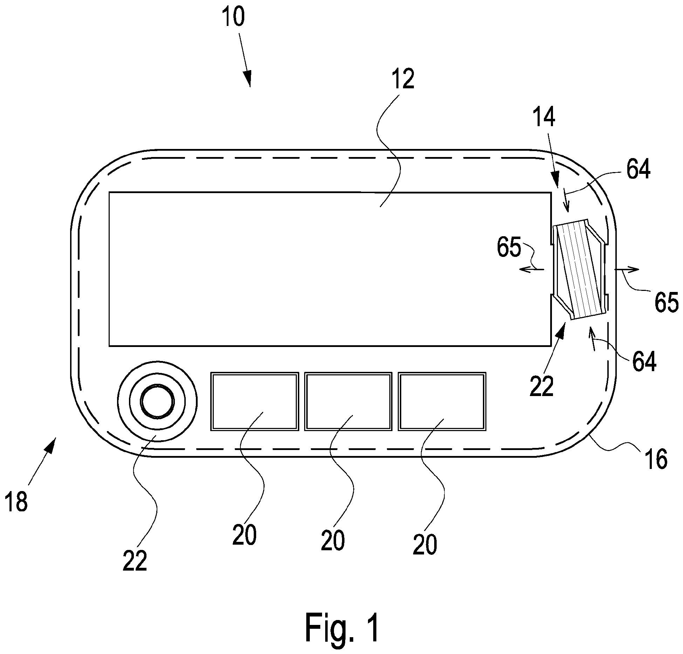

In Fig. 1 ist in Vorderansicht eine Bedieneinheit 10 für ein Fahrzeug gezeigt, bei der das Bedienelement 12 als Touch-Screen oder Touch-Pad ausgebildet ist, an dem eine gültige Bedienbefehleingabe durch eine impulsartige mechanische Anregung taktil zurückgemeldet wird (haptisches Feedback). Zu diesem Zweck weist die Bedieneinheit 10 einen Piezoantrieb 14 auf, der z.B. zwischen der Gehäusewand 16 des Gehäuses 18 der Bedieneinheit 10 und dessen Bedienelement 12 angeordnet und wirksam ist. Neben dem Bedienelement 12 mit berührungssensitiver Eingabemöglichkeit kann die Bedieneinheit 10 beispielsweise noch andere Bedienelemente wie beispielsweise Tasten 20 und/oder einen Drehsteller 22 aufweisen.

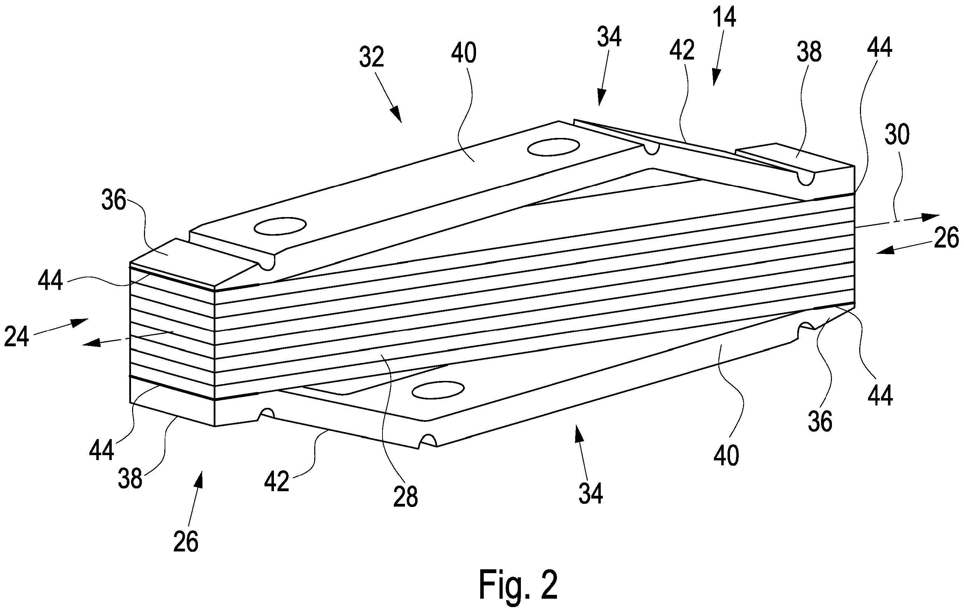

Eine vergrößerte Darstellung des Piezoantriebs 14 zeigt Fig. 2 perspektivisch. Der Piezoantrieb 14 weist einen Piezoaktuator 24 auf, der als strangförmiges, in diesem Ausführungsbeispiel stabförmiges Element mit einer Längserstreckung ausgebildet ist, die auch seine Wirkrichtung definiert. Der Piezoaktuator 24 weist zwei gegenüberliegende Längserstreckungsenden 26 auf und ist in diesem Ausführungsbeispiel als Stapel aus jeweils streifenförmigen piezoelektrischen Elementen ausgebildet. Wenn an die piezoelektrischen Elemente 28 eine elektrische Spannung angelegt wird, dehnt sich der Piezoaktuator 24 orthogonal zu seiner Längserstreckung aus (oder je nach Polung der angelegten Spannung kontrahiert er in dieser Richtung), was bedeutet, dass er sich in Längserstreckung zusammenzieht (bzw. je nach Polung der zuvor angesprochenen Spannung ausdehnt). In diesem Ausführungsbeispiel ist also die Wirkrichtung 30 des Piezoaktuators 24 durch dessen Längserstreckung definiert.

Beidseitig des Piezoaktuators 24 bzw. beidseitig der Wirkrichtung 30 befindet sich ein Umsetzungsgetriebe 32, dass in diesem Ausführungsbeispiel zwei Metallbügel 34 aufweist. Jeder Metallbügel umfasst zwei Endabschnitte 36, 38, wobei zwischen den beiden Endabschnitten 36,38 zwei schräg verlaufende Abschnitte, d.h. zwei Schrägabschnitte 40,42 angeordnet sind. Die beiden Schrägabschnitte 40,42 sind untereinander flexibel verbunden, was in diesem Ausführungsbeispiel durch ein Festkörpergelenk in Form einer Verringerung der Dicke des Metallbügels 34 realisiert ist. Einer der beiden Schrägabschnitte, nämlich der erste Schrägabschnitt 40, ist länger als der andere Schrägabschnitt, d.h. länger als der zweite Schrägabschnitt 42. Der erste Schrägabschnitt 40 ist flexibel mit dem ersten Endabschnitt 36 verbunden, während der zweite Schrägabschnitt 42 flexibel mit dem zweiten Endabschnitt 38 des Bügels 34 verbunden ist. Die Endabschnitte 36,38 beider Bügel 34 sind mittels Kleber 44 mit den Enden 26 des Piezoaktuators 24 schubsteif verbunden.

Die Kinematik des Piezoantriebs 14 ist wie folgt. Bei entsprechender elektrischer Ansteuerung des Piezoaktuators 24 verkürzt sich dieser in Längserstreckung, also in seiner Wirkrichtung 30, was bedeutet, dass sich die beiden Bügel 34 aufstellen, also nach außen bzw. bezogen auf die Darstellung gemäß Fig. 2 nach oben bzw. nach unten bewegen. Wenn die elektrische Ansteuerung des Piezoaktuators 24 derart gewählt ist, dass sich der Piezoaktuator in Längserstreckung ausdehnt, so bewegen sich die Bügel 34 in Richtung Piezoaktuator 24, nehmen also eine flachere Gestalt an. Der in beiden Fällen realisierte Bewegungshub wird nun genutzt, um, bezogen auf den Anwendungsfall gemäß Fig. 1, das Bedienelement 12 kurzzeitig mechanisch anzuregen. Dazu ist das Bedienelement 12 mit dem längeren ersten Schrägabschnitt 40 eines der beiden Bügel 34 verbunden, während sich das Umsetzungsgetriebe 32 mittels des längeren ersten Schrägabschnitts 40 des anderen Bügels 34 an der Gehäusewand 16 abstützt. Die relativ langen ersten Schrägabschnitte 40 der Bügel 34 machen es möglich, dass Kippbewegungen bei der mechanischen Anregung des Bedienelements 12 weitestgehend unterbunden werden.

Bei der Umsetzung der Längenveränderung des Piezoaktuators 24 in einen Bewegungshub für das Bedienelement 12 dienen die beiden längeren ersten Schrägabschnitte 40 der beiden Bügel 34 als kraftübertragende Elemente, während die kürzeren zweiten Schrägabschnitte 42 als Stützelemente für diese kraftübertragenden Elemente dienen.

Wie anhand von Fig. 2 und auch in Fig. 1 zu erkennen ist, sind die beiden Bügel 34 im Wesentlichen gleich konstruiert jedoch gegensinnig verlaufend angeordnet. Dadurch bilden die vier Schrägabschnitte 40,42 sozusagen die Seiten eines Parallelogramms (bei Betrachtung des Piezoantriebs 14 von der Seite).

In Fig. 2 ist auch gezeigt, dass die ersten Endabschnitte 36 der beiden Bügel 34 angeschrägt sind. Der Grund dafür ist, dass die an den ersten Schrägabschnitten 40 anliegenden Bauteile (Bedienelement 12 und Gehäusewand 16 im Ausführungsbeispiel der Fig. 1) im Bereich der (ersten) Endabschnitte 36 freiliegen und diese nicht kontaktieren, wenn die Bügel 34 maximal aufgestellt sind. Alternativ könnten die beiden Bauteile auch Vorsprungsbereiche aufweisen (siehe Fig. 1), innerhalb derer sie über ihre den Bügeln 34 zugewandten Seiten überstehen, womit die Endabschnitte 36 nicht mehr mit den Bauteilen kollidieren.

Durch die Reduktion der Anzahl der Biegezonen auf die drei flexiblen (d.h. Gelenk-)Verbindungen pro Bügel 34 liegen die ersten Schrägabschnitte 40 der beiden Bügel 34, die einerseits den Kontakt zum Bedienelement 12 und andererseits die Abstützung zur Gehäusewand 16 bilden, schräg im Raum bzw. es liegt der Piezoaktuator 24 schräg zu den zuvor genannten Bauelementen. Dadurch kann die Robustheit des Piezoaktuators bzw. des Piezoantriebs deutlich erhöht werden, da ein ungewolltes "Überbiegen" und demzufolge ein mechanisches Versagen der Gelenke unwahrscheinlicher wird. Darüber hinaus erhöht sich der Wirkungsgrad des Piezoantriebs, da jedes Gelenk mechanische Verluste verursacht. Je geringer also die Anzahl der Gelenke ist, desto höher ist der Wirkungsgrad, da die mechanischen Verluste verringert sind.

### BEZUGSZEICHENLISTE

10 Bedieneinheit
12 Bedienelement
14 Piezoantrieb
16 Gehäusewand
18 Gehäuse
20 Tasten
22 Drehsteller
24 Piezoaktuator
26 Längserstreckungsenden des Piezoaktuators
28 piezoelektrisches Element
30 Wirkrichtung des Piezoaktuators
32 Umsetzungsgetriebe
34 Bügel
36 erster Endabschnitt eines Bügels
38 zweiter Endabschnitt eines Bügels
40 erster Schrägabschnitt eines ersten Bügels
42 zweiter Schrägabschnitt eines Bügels
44 Kleber

## Patentansprüche

1. Fahrzeug-Bedieneinheit mit taktiler Rückmeldung bei manueller Betätigung, mit
- einem Gehäuse (18),
- einem Bedienelement (12), das manuell betätigbar ist, und
- einem Piezoantrieb (14) zur pulsartigen mechanischen Anregung des Bedienelements (12),
- wobei der Piezoantrieb (14) zwischen einer Gehäusewand (16) des Gehäuses (18) und dem Bedienelement (12) angeordnet und versehen ist mit
- einem Piezoaktuator (24) aus einem piezoelektrischen Material, wobei der Piezoaktuator (24) strangförmig ausgebildet ist und eine Längserstreckung zwischen zwei Enden (26) aufweist und wobei die Längserstreckung des Piezoaktuators (24) dessen Wirkrichtung (30) definiert, längs derer der Piezoaktuator (24) bei Ansteuerung expandiert und/oder kontrahiert, und
- einem mechanisch mit den Längserstreckungsenden (26) des Piezoaktuators (24) gekoppelten Umsetzungsgetriebe (32) zum Umsetzten einer in Wirkrichtung (30) des Piezoaktuators (24) erfolgenden Längenveränderung des Piezoaktuators (24) in eine in einem Winkel von ungleich 0 Grad zur Längserstreckung des Piezoaktuators (24) gerichteten Bewegung eines mit dem Umsetzungsgetriebe (32) gekoppelten, zu bewegenden Elements,
- wobei das Umsetzungsgetriebe (32) einen ersten Bügel (34) ausweist, der elastisch ausgebildet ist und/oder elastisches Material aufweist und der im Bereich der Längserstreckungsenden (26) des Piezoaktuators (24) mit diesem mechanisch gekoppelt ist,
**dadurch gekennzeichnet,**
- **dass** der erste Bügel (34) einen ersten Endabschnitt (36) und einen zweiten Endabschnitt (38), innerhalb derer der erste Bügel (34) jeweils mit dem Piezoaktuator (24) mechanisch gekoppelt ist, und zwischen den beiden Endabschnitten (36,38) einen schräg verlaufenden ersten Schrägabschnitt (40) und einen im Vergleich zum ersten Schrägabschnitt (40) kürzeren, schräg verlaufenden zweiten Schrägabschnitt (42) aufweist, die sich nach Art der Seitenschenkel eines Dreiecks mit gedachter, zwischen den Endabschnitten (36,38) des Bügels (34) verlaufender Verbindungslinie als Basis erstrecken sowie miteinander verbunden, insbesondere elastisch verbunden sind, und von denen der erste Schrägabschnitt (40) mit dem ersten Endabschnitt (36) und der zweite Schrägabschnitt (42) mit dem zweiten Endabschnitt (38) verbunden, insbesondere elastisch verbunden ist, und
- **dass** der erste Bügel (34) mit dem Bedienelement (12) und der Piezoaktuator (24) mit der Gehäusewand (16) gekoppelt ist oder der erste Bügel (34) mit der Gehäusewand (16) und der Piezoaktuator (24) mit dem Bedienelement (12) gekoppelt ist.

2. Fahrzeug-Bedieneinheit nach Anspruch 1, **dadurch gekennzeichnet, dass** der erste Schrägabschnitt (40) des ersten Bügels (34) des Umsetzungsgetriebes (32) mechanisch mit dem Bedienelement (12) in Wirkverbindung bringbar und der Piezoaktuator (24) an der Gehäusewand abstützbar ist oder dass der erste Schrägabschnitt (40) des ersten Bügels (34) des Umsetzungsgetriebes (32) mechanisch mit der Gehäusewand (16) in Wirkverbindung bringbar und der Piezoaktuator (24) an dem Bedienelement (12) abstützbar ist.

3. Fahrzeug-Bedieneinheit nach Anspruch 1, **dadurch gekennzeichnet, dass** das Umsetzungsgetriebe (32) einen zweiten Bügel (34) aufweist, der gleich dem oder im Wesentlichen gleich dem ersten Bügel (34) des Umsetzungsgetriebes (32) ausgebildet ist, wobei die Längen der ersten Schrägabschnitte (40) der beiden Bügel (34) unterschiedlich sind oder gleich oder im Wesentlichen gleich sind und die Längen der zweiten Schrägabschnitte (42) der beiden Bügel (34) unterschiedlich sind oder gleich oder im Wesentlichen gleich sind.

4. Fahrzeug-Bedieneinheit nach Anspruch 3, **dadurch gekennzeichnet, dass** der erste Schrägabschnitt (40) des einen der beiden Bügel (34) des Umsetzungsgetriebes (32) mechanisch mit dem Bedienelement (14) in Wirkverbindung bringbar ist und dass der erste Schrägabschnitt (40) des anderen der beiden Bügel (34) des Umsetzungsgetriebes (32) zur Abstützung des Umsetzungsgetriebes (32) mechanisch mit der Gehäusewand (16) statt einem Abstützelement koppelbar ist.

5. Fahrzeug-Bedieneinheit nach einem der Ansprüche 3 oder 4, **dadurch gekennzeichnet, dass** die beiden Bügel (34) des Umsetzungsgetriebes (32) beidseitig des Piezoaktuators (24) gleichsinnig ausgerichtet verlaufend angeordnet sind, wobei die beiden ersten Schrägabschnitte (40) und die beiden zweiten Schrägabschnitte (42) als paarweise gegenüberliegend sowie beide Paare längs der Wirkrichtung (30) des Piezoaktuators (24) nebeneinanderliegend angeordnet sind.

6. Fahrzeug-Bedieneinheit nach einem der Ansprüche 3 oder 4, **dadurch gekennzeichnet, dass** die beiden Bügel (34) des Umsetzungsgetriebes (32) beidseitig des Piezoaktuators (24) gegensinnig ausgerichtet verlaufend angeordnet sind, wobei der erste Schrägabschnitt (40) des einen Bügels (34) dem zweiten Schrägabschnitt (42) des anderen Bügels (34) jeweils paarweise gegenüberliegend sowie die beiden Paare längs der Wirkrichtung (30) des Piezoaktuators (24) nebeneinanderliegend angeordnet sind.

7. Fahrzeug-Bedieneinheit nach einem der Ansprüche 1 bis 6, **dadurch gekennzeichnet, dass** der erste Schrägabschnitt (40) des mindestens einen Bügels (34) oder jedes Bügels (34) des Umsetzungsgetriebes (32) mindestens die 1,5-fache Länge oder mindestens die 2-fache Länge oder mindestens die 2,5-fache Länge oder mindestens die 3-fache Länge seines zweiten Schrägabschnitts (42) aufweist.

8. Fahrzeug-Bedieneinheit nach einem der Ansprüche 3 bis 7, **dadurch gekennzeichnet, dass** die ersten Schrägabschnitte (40) beider Bügel (34) des Umsetzungsgetriebes (32) gleich lang sind und/oder dass die zweiten Schrägabschnitte (42) beider Bügel (34) gleich lang sind.

9. Fahrzeug-Bedieneinheit nach einem der Ansprüche 1 bis 8, **dadurch gekennzeichnet, dass** der mindestens eine Bügel (34) des Umsetzungsgetriebes (32) oder jeder Bügel (34) Metall oder Kunststoff aufweist.

10. Fahrzeug-Bedieneinheit nach einem der Ansprüche 1 bis 9, **dadurch gekennzeichnet, dass** pro Bügel (34) des Umsetzungsgetriebes (32) die Endabschnitte (36,38) mit dem jeweiligen Schrägabschnitt (40, 42) und die beiden Schrägabschnitte (40, 42) untereinander gelenkig verbunden sind.

11. Fahrzeug-Bedieneinheit nach einem der Ansprüche 1 bis 10, **dadurch gekennzeichnet, dass** die Endabschnitte (36, 38) des mindestens einen Bügels (34) des Umsetzungsgetriebes (32) oder jedes Bügels (34) klebend oder mittels eines Verbindungselements mit dem Piezoaktuator (24) mechanisch verbunden sind.

## Claims

1. A vehicle operating unit with tactile feedback upon manual actuation, comprising
- a housing (18),
- an operating element (12) which is adapted to be manually actuated, and
- a piezo driver (14) for pulsed mechanical excitation of the operating element (12),
- wherein the piezo driver (14) is arranged between a housing wall (16) of the housing (18) and the operating element (12) and provided with
- a piezo actuator (24) made from a piezoelectric material, wherein the piezo actuator (24) is of a strand-shaped configuration and has a longitudinal extension between two ends (26) and wherein the longitudinal extension of the piezo actuator (24) defines the effective direction (30) of the latter along which the piezo actuator (24) expands and/or contracts when being driven, and
- a conversion gear (32) mechanically coupled to the longitudinal extension ends (26) of the piezo actuator (24) for converting a length change of the piezo actuator (24) occurring in the effective direction (30) of the piezo actuator (24) into a movement of an element, which is coupled to the conversion gear (32) and to be moved, at an angle not equal to 0 degree relative to the longitudinal extension of the piezo actuator (24),
- wherein the conversion gear (32) comprises a first bracket (34) which is of an elastic configuration and/or comprises an elastic material and, in the area of the longitudinal extension ends (26) of the piezo actuator (24), is mechanically coupled to the latter,
**characterized in**
- **that** the first bracket (34) comprises a first end portion (36) and a second end portion (38), within which the first bracket (34) is respectively mechanically coupled to the piezo actuator (24), and between the two end portions (36, 38) an oblique first inclined portion (40) and an oblique second inclined portion (42), that is shorter as compared to the first inclined portion (40), which extend like the sides of a triangle with an imaginary connecting line extending between the end portions (36, 38) of the bracket (34) as a basis and are connected to each other, in particular elastically connected to each other, and where the first inclined portion (40) is connected, in particular elastically connected, to the first end portion (36) and the second inclined portion (42) is connected, in particular elastically connected, to the second end portion (38), and
- **that** the first bracket (34) is coupled to the operating element (12) and the piezo actuator (24) is coupled to the housing wall (16), or the first bracket (34) is coupled to the housing wall (16) and the piezo actuator (24) is coupled to the operating element (12).

2. The vehicle operating unit according to claim 1, **characterized in that** the first inclined portion (40) of the first bracket (34) of the conversion gear (32) is adapted to be mechanically operatively connected to the operating element (12) and the piezo actuator (24) is adapted to be supported on the housing wall, or that the first inclined portion (40) of the first bracket (34) of the conversion gear (32) is adapted to be mechanically operatively connected to the housing wall (16) and the piezo actuator (24) is adapted to be supported on the operating element (12).

3. The vehicle operating unit according to claim 1, **characterized in that** the conversion gear (32) comprises a second bracket (34) which is of the same or essentially the same configuration as the first bracket (34) of the conversion gear (32), wherein the lengths of the first inclined portions (40) of the two brackets (34) are different or the same or essentially the same and the lengths of the second inclined portions (42) of the two brackets (34) are different or the same or essentially the same.

4. The vehicle operating unit according to claim 3, **characterized in that** the first inclined portion (40) of one of the two brackets (34) of the conversion gear (32) is adapted to be mechanically operatively connected to the operating element (14) and that the first inclined portion (40) of the other one of the two brackets (34) of the conversion gear (32) is adapted to be mechanically coupled to the housing wall (16) instead of to a supporting element to support the conversion gear (32).

5. The vehicle operating unit according to any one of claims 3 or 4, **characterized in that** the two brackets (34) of the conversion gear (32) are arranged such that they are concurrently aligned on both sides of the piezo actuator (24), wherein the two first inclined portions (40) and the two second inclined portions (42) are arranged in pairs opposite each other and the two pairs are arranged side by side along the effective direction (30) of the piezo actuator (24).

6. The vehicle operating unit according to any one of claims 3 or 4, **characterized in that** the two brackets (34) of the conversion gear (32) are arranged such that they are counterconcurrently aligned on both sides of the piezo actuator (24), wherein the first inclined portion (40) of the one bracket (34) is respectively arranged opposite the second inclined portion (42) of the other bracket (34) such that they form pairs and the two pairs are arranged side by side along the effective direction (30) of the piezo actuator (24).

7. The vehicle operating unit according to any one of claims 1 to 6, **characterized in that** the first inclined portion (40) of the at least one bracket (34) or of each bracket (34) of the conversion gear (32) has at least 1.5 times the length or at least 2 times the length or at least 2.5 time the length or at least 3 times the length of the second inclined portion (42) thereof.

8. The vehicle operating unit according to any one of claims 3 to 7, **characterized in that** the first inclined portions (40) of the two brackets (34) of the conversion gear (32) have the same length, and/or that the second inclined portions (42) of the two brackets (34) have the same length.

9. The vehicle operating unit according to any one of claims 1 to 8, **characterized in that** the at least one bracket (34) of the conversion gear (32) or of each bracket (34) comprises metal or a plastic material.

10. The vehicle operating unit according to any one of claims 1 to 9, **characterized in that** per bracket (34) of the conversion gear (32), the end portions (36,38) are articulated to the respective inclined portion (40, 42) and the two inclined portions (40, 42) are articulated to each other.

11. The vehicle operating unit according to any one of claims 1 to 10, **characterized in that** the end portions (36, 38) of the at least one bracket (34) of the conversion gear (32) or of each bracket (34) are mechanically connected to the piezo actuator (24) either by means of an adhesive or by means of a connecting element.

## Revendications

1. Unité de commande pour véhicule avec rétroaction tactile en cas d'actionnement manuel, dotée
- d'un boîtier (18),
- d'un élément de commande (12) actionnable manuellement, et
- d'un entraînement piézoélectrique (14) destiné à l'excitation mécanique pulsée de l'élément de commande (12),
- dans laquelle l'entraînement piézoélectrique (14) est disposé entre une paroi (16) du boîtier (18) et l'élément de commande (12) et est prévu doté
- d'un actionneur piézoélectrique (24) constitué d'un matériau piézoélectrique, dans laquelle l'actionneur piézoélectrique (24) est réalisé en forme de bandes et comporte une étendue longitudinale entre deux extrémités (26) et dans laquelle l'étendue longitudinale de l'actionneur piézoélectrique (24) définit la direction d'action (30) de ce dernier, le long de laquelle l'actionneur piézoélectrique (24) se dilate et/ou se contracte en cas d'activation, et
- d'un engrenage de conversion mécanique (32) couplé aux extrémités longitudinales (26) de l'actionneur piézoélectrique (24), destiné à convertir une variation de longueur de l'actionneur piézoélectrique (24) s'effectuant dans la direction d'action (30) de l'actionneur piézoélectrique (24) en un mouvement, orienté à un angle différent de 0° par rapport à l'étendue longitudinale de l'actionneur piézoélectrique (24), d'un élément à déplacer couplé à l'engrenage de conversion (32),
- dans laquelle l'engrenage de conversion (32) comporte un premier étrier (34), lequel est réalisé comme élastique et/ou comporte un matériau élastique et est couplé mécaniquement à l'actionneur piézoélectrique (24) dans la zone des extrémités longitudinales (26) de ce dernier,
**caractérisée**
- **en ce que** le premier étrier (34) comporte une première section d'extrémité (36) et une deuxième section d'extrémité (38), à l'intérieur desquelles le premier étrier (34) est respectivement couplé à l'actionneur piézoélectrique (24) de manière mécanique, et comporte entre les deux sections d'extrémité (36, 38) une première section oblique (40) s'étendant obliquement et une deuxième section oblique (42) plus courte que la première section oblique (40) et s'étendant obliquement, lesquelles s'étendent à la manière des côtés d'un triangle avec comme base une ligne de liaison imaginaire s'étendant entre les sections d'extrémité (36, 38) de l'étrier (34) et sont également reliées l'une à l'autre, en particulier de manière élastique, et desquelles la première section oblique (40) est reliée à la première section d'extrémité (36) et la deuxième section oblique (42) est reliée à la deuxième section d'extrémité (38), en particulier reliées de manière élastique, et
- **en ce que** le premier étrier (34) est couplé à l'élément de commande (12) et l'actionneur piézoélectrique (24) est couplé à la paroi de boîtier (16) ou le premier étrier (34) est couplé à la paroi de boîtier (16) et l'actionneur piézoélectrique (24) est couplé à l'élément de commande (12).

2. Unité de commande pour véhicule selon la revendication 1, **caractérisée en ce que** la première section oblique (40) du premier étrier (34) de l'engrenage de conversion (32) peut être mécaniquement amenée en liaison opérante avec l'élément de commande (12) et l'actionneur piézoélectrique (24) peut s'appuyer sur la paroi de boîtier ou **en ce que** la première section oblique (40) du premier étrier (34) de l'engrenage de conversion (32) peut être mécaniquement amenée en liaison opérante avec la paroi de boîtier (16) et l'actionneur piézoélectrique (24) peut s'appuyer sur l'élément de commande (12).

3. Unité de commande pour véhicule selon la revendication 1, **caractérisée en ce que** l'engrenage de conversion (32) comporte un deuxième étrier (34), lequel est réalisé de manière identique ou sensiblement identique au premier étrier (34) de l'engrenage de conversion (32), dans laquelle les longueurs des premières sections obliques (40) des deux étriers (34) sont différentes ou égales ou sensiblement égales et les longueurs des deuxièmes sections obliques (42) des deux étriers (34) sont différentes ou égales ou sensiblement égales.

4. Unité de commande pour véhicule selon la revendication 3, **caractérisée en ce que** la première section oblique (40) de l'un des deux étriers (34) de l'engrenage de conversion (32) peut être mécaniquement amenée en liaison opérante avec l'élément de commande (14) et **en ce que** la première section oblique (40) de l'autre des deux étriers (34) de l'engrenage de conversion (32) peut être mécaniquement couplée avec la paroi de boîtier (16) plutôt qu'avec un élément de soutien afin de soutenir l'engrenage de conversion (32).

5. Unité de commande pour véhicule selon l'une des revendications 3 ou 4, **caractérisée en ce que** les deux étriers (34) de l'engrenage de conversion (32) sont disposés des deux côtés de l'actionneur piézoélectrique (24) et orientés de manière identique, dans laquelle les deux premières sections obliques (40) et les deux deuxièmes sections obliques (42) sont disposées en opposition par paires et les deux paires sont également disposées l'une à côté de l'autre le long de la direction d'action (30) de l'actionneur piézoélectrique (24).

6. Unité de commande pour véhicule selon l'une des revendications 3 ou 4, **caractérisée en ce que** les deux étriers (34) de l'engrenage de conversion (32) sont disposés des deux côtés de l'actionneur piézoélectrique (24) et orientés de manière opposée, dans laquelle la première section oblique (40) de l'un étrier (34) est disposée respectivement en opposition par paire par rapport à la deuxième section oblique (42) de l'autre étrier (34) et les deux paires sont également disposées l'une à côté de l'autre le long de la direction d'action (30) de l'actionneur piézoélectrique (24).

7. Unité de commande pour véhicule selon l'une des revendications 1 à 6, **caractérisée en ce que** la première section oblique (40) de l'au moins un étrier (34) ou de chaque étrier (34) de l'engrenage de conversion (32) présente au moins 1,5 fois ou au moins 2 fois ou au moins 2,5 fois ou au moins 3 fois la longueur de sa deuxième section oblique (42).

8. Unité de commande pour véhicule selon l'une des revendications 3 à 7, **caractérisée en ce que** les premières sections obliques (40) des deux étriers (34) de l'engrenage de conversion (32) sont de longueur identique et/ou **en ce que** les deuxièmes sections obliques (42) des deux étriers (34) sont de longueur identique.

9. Unité de commande pour véhicule selon l'une des revendications 1 à 8, **caractérisée en ce que** l'au moins un étrier (34) de l'engrenage de conversion (32) ou chaque étrier (34) comporte du métal ou du plastique.

10. Unité de commande pour véhicule selon l'une des revendications 1 à 9, **caractérisée en ce que**, par étrier (34) de l'engrenage de conversion (32), les sections d'extrémité (36, 38) sont reliées à la section oblique respective (40, 42) et les deux sections obliques (40, 42) sont reliées l'une à l'autre de manière articulée.

11. Unité de commande pour véhicule selon l'une des revendications 1 à 10, **caractérisée en ce que** les sections d'extrémité (36, 38) de l'au moins un étrier (34) de l'engrenage de conversion (32) ou de chaque étrier (34) sont reliées mécaniquement à l'actionneur piézoélectrique (24) par adhésif ou au moyen d'un élément de liaison.
